# EUROPEAN PATENT APPLICATION

(11) **EP 1 363 330 A2**
(43) Date of publication of application: **19.11.2003**
(21) Application number: 03425299.9
(22) Date of filing: 12.05.2003
(51) Int. Cl.: H01L 27/02, H01L 29/94

(54) **Fabrication of an integrated voltage sensing capacitor**

(30) Priority: 15.05.2002 IT VA20020034
(71) Applicant: STMicroelectronics S.r.l., 20041 Agrate Brianza (Milano) (IT)
(72) Inventor: Aiello, Natale, 95039 Trecastagni (IT); Patti, Davide, 95122 Catania (IT)
(74) Representative: Pellegri, Alberto

(57) **Abstract**

A capacitor for sensing the substrate voltage is efficiently and economically realized simply by isolating a portion or segment of the metal layer that normally covers the heavily doped perimetral region of electric field equalization and, in correspondence of such a metal segment isolated by the remaining portion, by not removing preventively the isolation dielectric layer of silicon oxide from the surface of the semiconductor substrate, as it is normally done on the remaining portion of the perimetral edge region before depositing the metal. The unremoved layer of isolated silicon oxide becomes the dielectric layer of the so constituted capacitor, a plate of which is the heavily doped perimetral region that is electrically connected to the substrate (drain or collector region) while the other plate is constituted by the segment of metal, isolated from the remaining metal layer defined directly over the heavily doped perimetral region.

## Description

### FIELD OF THE INVENTION

The present invention relates in general to semiconductor power devices. Although the invention is useful also in case of discrete power devices, the invention is particularly useful for power devices co-integrated on the same chip together with drive and control circuits.

### BACKGROUND OF THE INVENTION

In general, in a monolithic semiconductor power device, for example realized with the technology called VIPower, a divider or an equivalent element for monitoring the substrate voltage must be integrated in the sector where it is realized the low voltage control circuitry.

According to a first known approach the function is implemented by realizing an integrated divider resistor between the substrate and the control region.

According to an alternative approach, the detection element may be an integrated capacitor through which variations of the substrate voltage may be sensed.

Typically, in these devices the substrate coincides with the collector or drain terminal or electrode of the power transistor that in many cases (VIPower, PIC (acronym for Power Integrated Circuit), and alike commercial products) is connected to the external circuit through a bottom or back metal layer of the substrate. Relatively high voltages may be applied to the substrate, for example up to 2000 V, and thus any integrated divider resistor of the voltage or integrated capacitor, used for sensing the substrate voltage, must withstand voltages of this order of magnitude.

In case a capacitor is employed for sensing voltage variations of the substrate, the capacitor is commonly realized in the form of a p/n junction. This commonly used approach is burdened by drawbacks such as for instance the strong dependence of the capacitance value from the applied voltage. In particular for relatively high (>100 V) voltages the capacitance tends to decrease to very small values, thus making detection of voltage variations on it very difficult.

This problem, which is typical of common integrated junction capacitors, may be overcome by realizing a dielectric type capacitor. Obviously, the thickness and electrical characteristics of the dielectric material must be appropriate to withstand the intense electric field that may be present between the capacitor plates, at the highest rated voltage. Silicon oxide, deposited or grown according to common fabrication techniques of semiconductor devices, is an excellent dielectric and it may be realized even with a relatively large thickness (around 1-2 µm) without any problem when fabricating the device.

Nevertheless, the need of using a relatively thick dielectric heavily penalizes the capacitance that may be obtained per unit area, according to the known physical law (C = ε₀ εᵣ A/d), where "d" is the thickness of the dielectric and "A" is the area of the capacitor.

In order to obtain capacitors of sufficiently large capacitance for ensuring a secure and simple sensing of substrate voltage variations, even at very low frequencies, it is necessary to occupy a relatively large integration area. This represents a severe burden in integrating dielectric type capacitors for sensing the substrate voltage in monolithic semiconductor power devices, and often this is the reason why designers tend to favor less burdensome alternatives to the use of a dielectric type summing capacitor.

### OBJECT AND SUMMARY OF THE INVENTION

The main object of this invention is to render integration of a high voltage dielectric type capacitor for sensing the substrate voltage in monolithic power devices less burdensome from the point of view of the silicon area consumption.

The present invention outstandingly reaches this objective by allowing an extreme simplicity of realization with a practically negligible area requirement.

Basically, the gist of the invention consists in exploiting the typical edge or perimetral structure of a monolithic semiconductor power device for realizing a capacitor perfectly suited for sensing substrate voltage.

As it is well known to any skilled person, in all semiconductor power devices, whether integrated or discrete, there is always on the chip a perimetral or edge diffused region (diffusion), one or more tens of µm wide, typically with a width of about 20-50 µm that surrounds the area of integration of the device and from which it is spaced by a generally uniform distance, typically of several tens of µm, commonly ranging from 50 to 150 µm. This edge region is heavily doped with a dopant of the same type of conductivity of the substrate to which this diffused region is thus electrically connected.

The function of this edge or perimetral region, heavily doped to be highly conducting, is of making as uniform as possible the electric field around the device.

Most often, on this region and directly in contact with the doped silicon, a continuous metal layer is deposited and defined in order to make even more conducting such an annular structure at the collector or drain voltage that surrounds the area occupied by the power device and possibly also by the drive and control circuitry of the power device.

In practice, being this perimetral or edge region so highly conducting and in electric continuity with the semiconducting substrate, it may be considered to constitute a surfacing extension of the collector electrode that is commonly represented by the metallization layer of the back or bottom of the semiconductor chip.

It has been found that a capacitor for sensing the substrate voltage may be efficiently and economically realized simply by isolating a portion or segment of the metal layer that normally covers this heavily doped perimetral region of electric field equalization and, in correspondence of such a metal segment isolated by the remaining portion, by not removing preventively the isolation dielectric layer of silicon oxide from the surface of this semiconductor substrate, as it is normally done on the remaining portion of the perimetral edge region before depositing the metal. The unremoved layer of isolated silicon oxide becomes the dielectric layer of the so constituted capacitor, a plate of which is the heavily doped perimetral region that is electrically connected to the substrate (drain or collector region) while the other plate is constituted by the segment of metal, isolated from the remaining metal layer defined directly over the heavily doped perimetral region.

Therefore, it will be sufficient to define through successive process steps a conducting path of electrical connection of the second plate to a relative voltage sensing node of the circuit for monitoring the substrate voltage.

Such a substrate voltage sensing capacitor besides having a negligible area requirement is a dielectric type capacitor and as such is not subject to changes of capacitance dependent on variations of the applied voltage. Moreover, the relatively large thickness of the layer of isolation oxide (commonly above 1 µm) that is normally deposited over the perimetral area, according to the common fabrication processes of these devices, and which is removed on the surface of the heavily doped electric field equalization perimetral region before depositing directly in contact with the heavily doped perimetral region a metal layer, is perfectly capable of withstanding the rated voltage (up to or even above 2000 V).

The invention is clearly defined in the annexed claims.

### DESCRIPTION OF THE DRAWINGS

**Figure 1** is a plant view of the layout of a chip for evaluating and practically proving the effectiveness of the present invention.
**Figure 2** is a magnified view of the portion of interest of the layout of a test device of Figure 1.
**Figure 3** is a schematic sectional view of the structure of the sensing capacitor of the invention.

### DESCRIPTION OF AN EMBODIMENT OF THE INVENTION

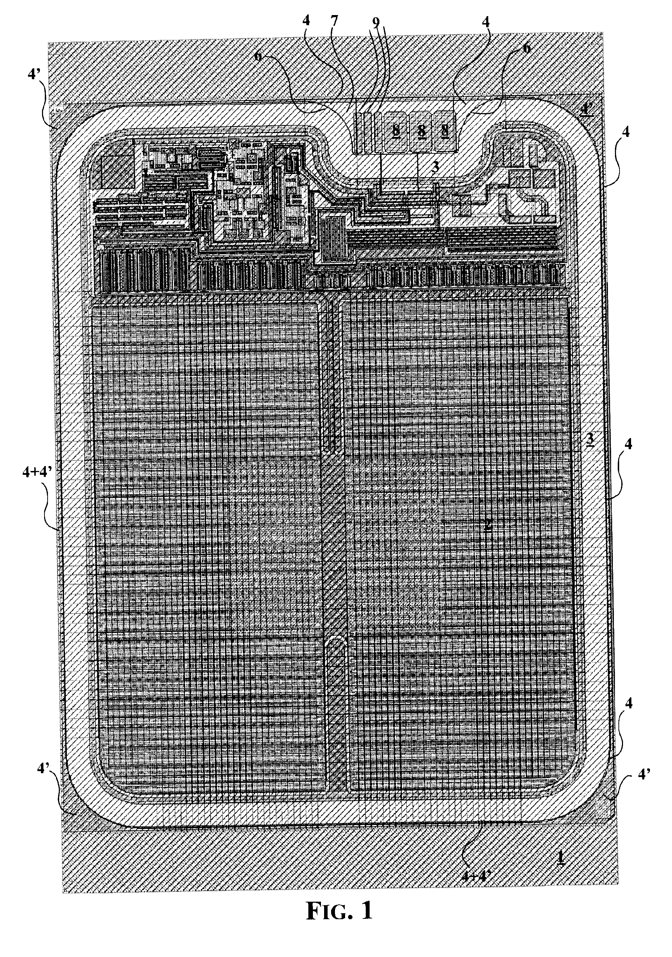

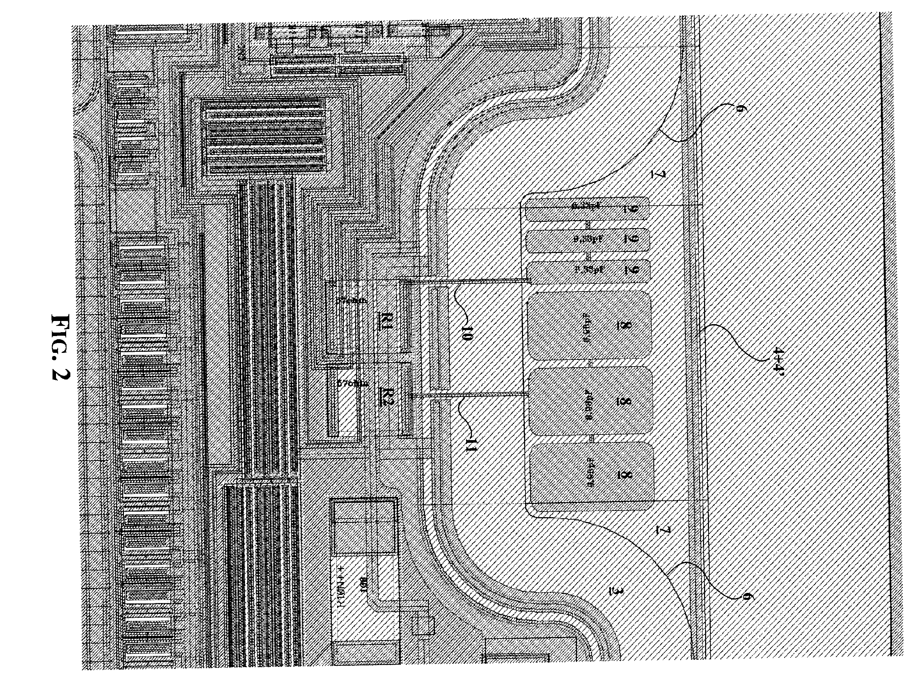

Figures 1 and 2 depict the layout of a test power device realized for proving effectiveness of the invention as well as for defining the most appropriate dimensions of the capacitor for sensing voltage variations of the collector (or drain) of the power transistor, physically coinciding with the substrate of the silicon chip 1.

The considered test case is that of a generic power device (transistor), whose collector or drain electrode (for instance in the case of a VIPOwer® device of STMicroelectronics) is constituted by a bottom or back metal layer of the chip 1.

As may be noticed from the full view of the layout of Figure 1, the structure of the power device is clearly recognizable and indicated by the numeral 2 while on the right portion of the layout, the drive and control circuitry of the power transistor 2 may be easily identified.

The numeral 3 indicates the perimetral area of separation, the width of which is usually comprised between 50 and 150 µm (in the test device it is about 150 µm), that surrounds completely the area 2 of integration of the power device structure and of the control and drive circuitry. This separation region 3 separates the silicon integrated structures from a heavily doped so-called perimetral edge diffused region 4, which is electrically connected with and thus at the same potential of the substrate. In the test device the width of this perimetral or edge diffused region 4 was about 30 µm.

As already mentioned, normally in order to increase the compounded electric conductivity of this heavily doped region 4 of equalization of the electric field along the border of the integrated circuit device, it is covered by a metal layer 4', that is formed directly on the semiconductor, by precedingly removing on this area the layer of silicon oxide of isolation. The removal of the layer of silicon oxide of isolation. The removal of the isolation oxide is done through the mask "contacts". The metal layer may even be defined so to be slightly wider than the underlying heavily doped edge diffusion 4.

In order to verify the effectiveness and to study the most appropriate dimensioning of the sensing capacitor according to the present invention, in the perimetral layout an enlargement 7 was deliberately realized by enlarging innerwise the heavily doped border region 4, whose profile in this zone of enlargement is indicated by the line 6.

Consequently, in correspondence of the enlargement of the edge diffusion 4, the separation region 3 runs along the inner side of the enlargement following a indent line.

In the area of enlargement 7 of the heavily doped border diffusion 4, the isolation oxide layer was not removed and over this dielectric layer two groups, of three plates each, were realized, respectively 8 and 9, having different dimensions, by properly depositing and defining the metal layer.

The area of the larger plates 8 was 12*10³ µm² while the area of the smaller plates 9 was 4.5*10³ µm².

The isolation silicon oxide under the plates 8 and 9 was about 1.5 µm thick.

A certain number of test devices so designed allowed to test various combinations of single connections and/or parallel connections of any one or of several plates the two sets 8 and 9, to verify the effectiveness of different capacitance values, modularly established in terms of a certain overall area of the dielectric integrated capacitor, the other plate of which is of course constituted by the underlying heavily doped perimetral diffusion 4 that is electrically connected to the substrate and thus to the collector (or drain) electrode of the power device.

In Figures 1 and 2 that show one of the used test devices, it is possible to notice the metal lines of electrical connection 10 and 11, respectively, of a plate of large area 8 and of a plate of fractional area 9, to respective integrated resistors R1 and R2, that could be alternatively selected.

Investigation using test devices as described above confirmed a perfect functioning and effectiveness of the sensing capacitor of the invention.

Tests on different combinations of area of the capacitor also confirmed that the area required by the capacitor is perfectly compatible to being realized in practice by simply isolating a segment, of a length appropriate for establishing the required area, of the metal layer 4', which is normally defined over the heavily doped border diffusion 4, and by leaving intact, in the area of this segment, the dielectric layer of isolation. In this way, a dielectric capacitor the upper plate of which is constituted by an isolated segment of the perimetral metal strip segment 4', and may be conventionally connected to the sensing node of the detection circuit of the voltage variations of the substrate, by realizing an appropriate metal interconnect is efficiently implemented without requiring any dedicated area.

In the area of the isolated metal segment, if necessary, the width of the edge diffusion 4 and of the metal layer 4' defined thereon may even be increased for best exploiting the available silicon area, in order to reduce the length of the metal segment to be isolated for constituting the sensing capacitor.

In case the detection and control circuitry of the power transistor is not integrated on the same chip, the isolated metal segment constituting the upper plate of the sensing capacitor may coincide or be connected to a dedicated connection pad for connection to an external detection and control circuit of the power device.

The interruption of the continuity of the metal layer 4' for a certain segment the length of which is in any case relatively small compared to the whole perimeter, does not influence in any detectable way the equalization function of the electric field that is performed by the perimetral ring structure constituted by the uninterrupted heavily doped border diffusion 4 and by the metal layer 4' in contact with the rest of the perimeter except for the relatively short isolated segment.

The main objective of the invention is thus fully attained.

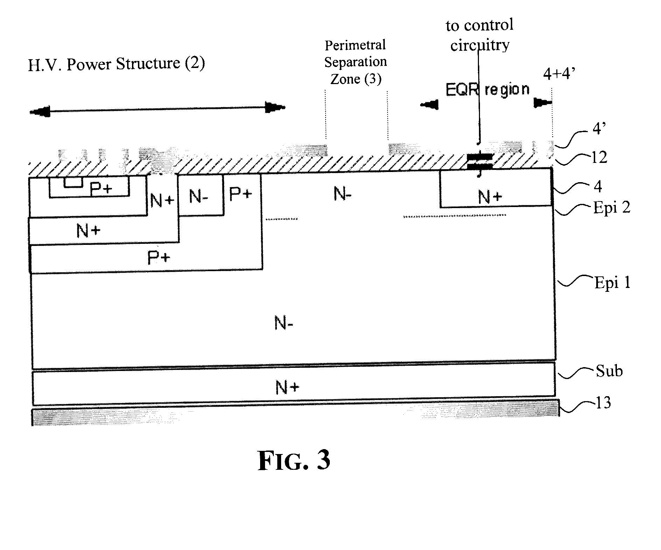

Even the process steps of fabrication of the device does not require any modification, as it is evident to a skilled person from the following description of a fabrication process of a device according to the present invention by referring to Figure 3.

The described process refers to a generic VIPower® only for illustration purposes. The structure of the sensing capacitor is realizable in any other fabrication process.

With reference to Figure 3, on a substrate with a high n+ type dopant concentration (region Sub), a first epitaxial layer is grown (region Epi 1), the concentration of n-type dopant and thickness of which are appropriately designed in function of the voltage class to which the device belongs.

On the first epitaxial layer Epi 1, by ion implantations and successive diffusion treatments, a buried p+ base region of the power transistor and a buried n+ emitter region of the power transistor are realized, thus constituting the necessary buried layers to build the power device.

Successively a second n- epitaxial layer (region Epi 2) is grown over the first epitaxial layer Epi 1.

Two diffusions are realized thereafter, respectively of p+ type and n+ type, by common photolithography, ion implantation and diffusion, to form deep low resistivity contacts with the previously formed buried regions n+ and p+ of the high voltage power device.

The n+ type diffusion is realized also in the perimetral edge region (EQR region). This heavily doped n+ region (EQR) of equalization of the edge electric field , indicated with the numeral 4 in the figures, is electrically connected with the substrate and, as described above, constitutes also the lower plate of the sensing capacitor of the invention, the electric symbol of which is indicated in Figure 3.

In practice, under the isolated metal segment 4' constituting the upper plate of the capacitor the dielectric layer 12 of isolation is left intact for constituting the dielectric of the sensing capacitor.

From this point, the sequence of steps of the fabrication process of the device may continue according to the usual process, by completing the structure of the power device with the contemplated layers and finally, by common photolithography and etching techniques, electric contacts and electrical interconnects lines are created.

Except from the isolated segment 4' of the patterned metal that realizes the upper plate of the sensing capacitor, the perimetral metal layer 4' is deposited directly on the semiconductor, in electrical contact with the heavily doped n+ region 4 of equalization of the electric field, by previously removing by masking and etching the layer of isolation oxide 12, over the isolated segment 4'.

In a VIPower, PIC or similar process for fabricating power integrated devices, the sensing capacitor according to the present invention may be realized simply by modifying the mask used for defining and opening the contacts and for exposing the silicon over the edge diffusion 4, except the segment with which the sensing capacitor is realized according to the present invention, and the metal patterning mask, because all the layers exploited for making the sensing capacitor according to the process of the invention are already present.

## Claims

1. A power device realized on a semiconductor substrate (1) of a first type of conductivity (n+) and in which a terminal or electrode of the device coincides with said substrate (1) connectable to an external circuit through a bottom metal layer (13) of the substrate, comprising an electric field equalizing heavily doped perimetral or edge diffused region (4) of the same kind of conductivity (n+) of the substrate and in electrical continuity with said terminal or electrode (13) of the device, optionally covered by a metal layer (4') for increasing the compound electrical conductivity of said perimetral electric field equalizing structure around the integration area of the device, at least a sensing capacitor of the voltage on said terminal or electrode (13) of the device connected to an external circuit, **characterized in that**
said sensing capacitor is constituted by a plate defined by isolating a segment of a certain length of said metal layer (4') defined over said perimetral diffused region (4), constituting the other plate of the capacitor and isolated from this diffused region by an isolation layer (12) of a dielectric material having a thickness sufficient to withstand the maximum voltage that may be applied to said terminal or electrode of the device;
said first plate being electrically connected to a node of a detection circuit of the voltage present on said terminal or electrode.

2. The device according to claim 1, wherein said first plate is as wide as said metal layer (4') defined over said perimetral diffusion (4).

3. The device according to claim 1, wherein said first plate is wider than said metal layer (4') defined over said perimetral diffusion (4).

4. The device of claim 1, **characterized in that** said detection circuit of the voltage is integrated on the same chip of the power device.

5. The device of claim 1, **characterized in that** the power device is an integrated bipolar junction transistor.

6. The device of claim 1, wherein the power device is an integrated field effect transistor.
